Europäisches Patentamt

European Patent Office

Office européen des brevets

(11) Publication number: **0 211 529**
**B1**

(12) **EUROPEAN PATENT SPECIFICATION**

(45) Date of publication of patent specification: **12.09.90**

(21) Application number: **86305324.5**

(22) Date of filing: **10.07.86**

(51) Int. Cl.[5]: **C 23 C 14/14,** C 23 C 14/18, C 23 C 14/34, H 01 L 21/203

(54) Method for forming CuInSe2 films.

(30) Priority: **16.07.85 US 755649**

(43) Date of publication of application:
**25.02.87 Bulletin 87/09**

(45) Publication of the grant of the patent:
**12.09.90 Bulletin 90/37**

(84) Designated Contracting States:
**DE FR GB IT NL**

(56) References cited:
**US-A-4 322 276**
**US-A-4 335 266**
**US-A-4 465 575**

**THIN SOLID FILMS, vol 90, 1982 M S TOMAR et al. " A ZnO /p-CuInSe2 Thin Film Solar Cell Prepared Entirely bx Spray Pyrolysis". pp 419-423.**
**SOLAR ENERGY RESEARCH INSTITUTE, final report, 15.11.1982 & 14.01.1982. POLY SOLAR INCORPORATED "Chemical Vapor Deposited Copper Indium Diselenide Thin Film Materials Research"**

(73) Proprietor: **ATLANTIC RICHFIELD COMPANY**
**515 South Flower Street**
**Los Angeles California 90071 (US)**

(72) Inventor: **Ermer, James H.**
**3376 Rowena Apt. 104**
**Los Angeles California (US)**
Inventor: **Love, Robert B.**
**10433 Lubao Avenue**
**Chatsworth California (US)**

(74) Representative: **Garratt, Peter Douglas et al**
**Mathys & Squire 10 Fleet Street**
**London EC4Y 1AY (GB)**

(56) References cited:

**SOLAR ENERGY MATERIALS, vol 2, no. 3, April-June 1980. J. PIEKOSZEWSKI et al. " RF-Sputtered CuInSe2 Thin Films", pp 363-372**

**JOURNAL OF THE ELECTROCHEMICAL SOCIETY, vol 131, no. 9, September 1984 T.L.CHU et al." Large Grain Copper Indium Diselenide Films" pp 2182-2185**

Courier Press, Leamington Spa, England.

**Description**

The present invention relates to thin film heterojunction photovoltaic cells having copper indium diselenide (CIS) as an active semiconductor layer and more particularly to a method for forming such CIS films.

References which illustrate the background of photovoltaic devices inluding CIS semiconductor layers include U.S Patent 4,335,266 issued to Mickelsen et al on June 15, 1982 and U.S. Patent 4,465,575 issued to Love et al on August 14. 1984. Both of these patents are hereby incorporated by reference. The Mickelsen patent provides considerable background information concerning development of CIS/cadimum sulfide (CdS) photovoltaic cells. Mickelsen teaches an improvement in the CIS deposition process involving the deposition of the CIS film in two slightly different regions. The first region has an excess of copper while the second region, which is ultimately adjacent the CdS layer, is copper deficient. Diffusion between the two regions forms the desired CIS layer while reducing the probability of formation of pure copper nodules at the device junction. The CIS materials are deposited in Mickelsen using the reactive evaporation technique in which the three elements are simultaneously evaporated onto a heated substrate to form the compound semiconductor as deposited.

The Love et al patent teaches a different reactive deposition method for manufacturing the same type of device as Mickelsen et al. The primary difference is the use of DC magnetron sputtering devices to deposit the copper, indium and selenium. In a preferred form, Love uses $Cu_2Se$ and $In_2Se_3$ targets to deposit CIS films. Alternatively, Love teaches codeposition of elemental copper, indium and selenium in a reactive deposition process.

Various other techniques have also been used to deposit CIS films. For example, the publication "RF-Sputtered $CuInSe_2$ Thin Films" by J. Piekoszewski et al, Solar Energy Materials 2(1980) 363—372, teaches the deposition of CIS films by RF sputtering from a synthesized target onto a heated substrate. Piekoszewski teaches that the particle size of powder from which the target is pressed is critical in terms of final film quality. Thus when a fine powder was used the resulting films were selenium deficient and indium rich. In the publication "large Grain Copper Indium Diselenide Films" by T.L. Chu et al, J. Electrochem. Soc., September 1984, page 2182, two other film deposition techiques were discussed. These techniques involve either vacuum evaporation or electroplating of separate copper and indium films and then heat treatment of the resulting compound film in an atmosphere containing selenium. This publication notes that the control of the copper to indium ratio is essential and use of separate deposition steps enhances the ability to control the ratio of materials deposited.

Two other publications discuss other methods for depositing CIS films and teach photovoltaic structures in which a junction is formed between a CIS film and a zinc oxide film. The firt of these is entitled "A $ZnO/p-CuInSe_2$ Thin Film Solar Cell Prepared Entirely By Spray Pyrolysis" by M.S. Tomar et al, Thin Solid Films, 90 (1982) 419—423. In Tomar, zinc oxide was deposited on a tin oxide coated glass substrate by spray pyrolysis at a substrate temperature of from 350 to 550°C. After similar deposition of a CIS layer, photovoltaic response of about 2% efficiency was measured. In the report entitled "Chemical Vapor Deposited Copper Indium Diselenide Thin Film Materials Research", Final Report, March 1984, SERI/STR-211-2247 by Poly Solar, Incorporated, zinc oxide films were ion beam sputtered onto CIS films which were deposited by a close space chemical vapor transport technique. Photovoltaic efficiencies in the range of 2 to 3% were achieved by such devices.

The above-referenced patents and publications indicate that much effort has been made to develop practical technique for depositing high quality CIS films for use in making good photovoltaic devices. While reasonable efficiencies have been achieved for very small area research type devices, not good method has been found for manufacturing large area, for example, at least 30 cm by 30 cm, devices. As noted in the various publications, it is essential that the proper stoichiometric ratio of materials be deposited to form the film. This has proven to be difficult even in research devices. For the large commerical devices devices very good uniformity must be achieved across large surface areas on a repeatable basis.

Accordingly, an object of the present invention is to provide an improved method for depositing high quality copper indium diselenide films.

In one form the present invention consists in a method for fabricating a copper indium diselenide semiconductor film comprising: depositing a film of copper on a substrate by DC magnetron sputtering; depositing indium on said film of copper by DC magnetron sputtering to form a composite film of copper and indium; heating sid composite film of copper and indium in the presence of selenium at a temperature and for a time selected to cause interdiffusion of copper, indium and selenium to form a copper indium diselenide film.

In a preferred form of the invention a photovoltaic device electrode is also deposited by a separate DC magnetron sputtering cathode on a substrate pgior to deposition of the copper film. Advantageously, the electrode, the copper and the indium, are deposited sequentially in a single vacuum chamber.

The present invention may be better understood by reading the following detailed description of the preferred embodiments with reference to the accompanying drawings wherein:

Figure 1 is a cross-sectional illustration of a photovoltaic device according to the present invention; and

Figure 2 is a illustration magnetron sputtering apparatus used in the present invention.

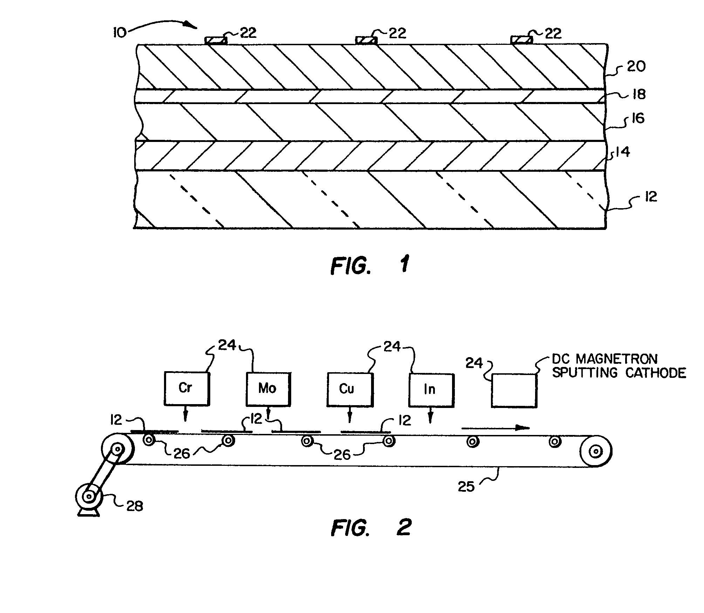

With the reference now to Figure 1, there is provided a cross-sectional illustration of a portion of a photovoltaic cell 10 fabricated using the method of the present invention. Cell 10 is structurally supported on a glass substrate 12, preferably soda lime glass, which is about 1 to 3 millimeters thick. A back contact comprises a metal layer 14 deposited upon substrate 12. Layer 14 comprises primarily a film of moybdenum which has been deposited by sputtering to a thickness of from 0.2 to 2.0 μm. In the preferred form, an initial film of chromium having a thickness of from 10 nm to 50 nm is first deposited upon glass 12 to insure good adhesion of the overall device to the substrate 12. The first active region of the device 10 comprises a semiconductor layer 16 which is p-type copper indium diselenide having an overall thickness of from about 0.2 to 2 μm. The improved method for depositing layer 16 is described in more detail below. The second active portion of the device 10 comprises layers 18 and 20 of n-type semiconductor material, such as CdS or ZnO. In the preferred embodiment, layers 18 and 20 are formed primarily of zinc oxide and are therefore essentially transparent to sunlight. Layer 18 is relatively pure zince oxide having a high resistivity and having a thickness ranging from about 10 nm to 200 nm. Layer 20 on the other hand includes various doping or alloy type materials to increase conductivity and has a thickness of about 1 μm. The device 10 is completed by a series of front face contacts 22 in the form of narrow metal strips which may be, for example, aluminum deposited by sputtering, evaporation or plating.

With reference now to Figure 2, there is provided a side view of a DC magnetron sputtering apparatus useful in the present invention with cathodes illustrated in block form. Such apparatus is well-known and commercially available. The equipment used in the preferred embodiment was acquired from Circuits Processing Apparatus, Inc. of Fremont, California under the designation 9900 series. This unit included ten cathodes, although only five are illustrated in Figure 2 for simplification. Though not illustrated, the apparatus of Figure 2 is housed in a vacuum chamber provided with loadlocks to allow substrates 12 to be placed into and taken from the chamber. The primary functional portions of the apparatus include the DC magnetron sputtering cathodes 24 which are generally linear in configuration and extend across the vacuum chamber. The apparatus used in developing the method of the present invention included ten of the magnetron sputtering cathodes 24. The apparatus also includes a pair of conveyor chains 25 supported on a series of rollers 26 and drive means 28 for moving the substrates 12 through the chamber at a controlled rate. Further details of the apparatus are provide in the above-referenced Love et al patent which has been incorporated by reference particularly for this purpose. While the cathodes 24 are illustrated as being above the substrate 12, they may also be placed on the bottom on the vacuum chamber below substrates 12 as illustrated in the Love et al patent. The samples discussed below were made with overhead cathodes.

Sample devices having the structure illustrated in Figure 1 were fabricated using apparatus as illustrated in Figure 2. In manufacturing these samples, the metallic targets were bonded to the surface of cathodes 24 and were 37.8 cm (14-7/8 inches) long, 12.1 cm (4-3/4 inches) wide and 0.6 cm (1/4 inch) thick. In contrast to the reactive sputtering technique of Love et al wherein multiple elements were sputtered from a given cathode, only a single element was sputtered from each of the cathodes 24 of Figure 2. These elements included chromium, molybdenum, copper and indium with each element being provided as a target having the specified dimensions. For all depositions the vacuum chamber was maintained at a pressure of 13.3 microbar (10 millitorr) of argon gas and substrates 12 where neither heated nor cooled. A first layer of chromium, approximatley 50 nm thick, was deposited on a soda lime glass substrate 12 by providing a cathode voltage of between 295 and 305 volts and current density of 5.0 to 5.5 mA/cm² (milliamps per square centimeter). These conditions resulted in a deposition rate of about 2.1 nm per second. An approximately two μm thick layer of molybdenum was deposited by providing a cathode voltage between 340 and 350 volts DC and current density of about 28.5 to 29.6 mA/cm². These conditions provided a molybdenum deposition rate of about 12.5 nm per second. A 200nm thick layer of copper was deposited by providing a cathode voltage between 388 and 395 volts DC and current density of 5.2 to 5.5 mA/cm². Copper deposition rate was about 6.4 nm/s.

Indium was deposited by providing a cathode voltage of from 400 to 410 volts DC and current density of 5.2 to 5.5 mA/cm², which conditions provided a deposition rate of about 6.6 nm/s.

For a given speed of substrate movement over the cathodes 12 the total film thickness deposited can be adjusted over a considerable range by adjusting cathode voltage and resulting current. Thicker films can be achieved by using two or more cathodes for the same material.

In a production situation each of these layers could be deposited sequentially in a single vacuum chamber and in a single pass of the substrate 12 through the chamber. For the experimental research devices which have been made, only a single material was deposited on a single pass of the substrate 12 through the vacuum chamber. This, of course allows better control of the process and allows observation or measurement of each layer to determine that it is properly deposited. At the given deposition rates the final thicknesses of some layers, for example molybdenum, were achieved by depositing the same material on two sequential passes. While the chamber had ten cathode structures it can be seen that only four were utilized in manufacturing the samples. In a production situation the equivalent of a double pass can of course be achieved by using two cathodes to deposit the same material, for example molybdenum.

As the process has been thus far described a layer of indium about 400 nm thick has been deposited over a layer of copper about 200 nm thick which provides a desired atomic ratio of about 1.0. The copper indium diselenide semiconductor layer 16 of Figure 1 is then formed by a process known as selenization. The substrate with the composite copper and indium films is placed in a separate furnace where it is heated to approximately 400°C in the presence of selenium, preferably 3% to 15% $H_2Se$ diluted in argon, for approximatley one hour and thereafter annealing the material an additional two hours at the same temperature. As a result of this process, the copper, indium and selenium interdiffuse and react to form a high quality copper indium diselenide film having a thickness of about 1.5 to 2.0 μm.

Having thus formed a good CIS film, a photovoltaic device may be completed by depositing various window layer materials thereon. As illustrated by the above-referenced patents, cadmium sulfide is a typical material used as a window layer. However, in the preferred embodiment, an essentially transparent zinc oxide film was used for this purpose. This film was deposited by a chemical deposition (CVD) process. The substrate 12 with the film 16 was placed in a vacuum chamber on a heated support. The chamber was evacuated and substrate temperature was adjusted to about 150°C and allowed to stabilize for about twenty minutes. For a total substrate area of about 900 cm (one square foot), the high resistivity zinc oxide layer 18 was formed by providing reactive gases comprising 8 sccm (standard cubic centimetres per minute) of diethyl zinc, 10 sccm $H_2O$ and 186 sccm of argon at a pressure of about 114.6 Pa (0.86 torr) while the initial temperature was maintained. Under these conditions a zinc oxide film of from 70 nm to 200 nm. thickness can be deposited in a time of two to six minutes. Layer 20 was then deposited by continuing the process with a different reactive gas mixture. This mixture included 8 sccm diethyl zinc, 10 sccm $H_2O$, 0.075 sccm $B_2H_6$ and 200 sccm argon. A high conductivity layer 18 having a thickness of about 1 μm may be deposited under these conditions in about thirty minutes process time.

The metal current collecting grid 22 may be formed on layer 20 using aluminum or silver metal deposited by any of the well-known methods.

Devices manufactured by this process have provided photovoltaic efficiencies exceeding 7%. Sample devices in which layers 18 and 20 were formed from CdS, as taught in the Mickelsen et al and Love et al patents, but which were otherwise identical also provided efficiencies in excess of 7%. The sample devices had areas of four square centimeters which were relatively large compared to many of the reported research devices. The processes were actually performed on three by three arrays of square substrates each ten centimeters by ten centimeters placed on a carrier having overall dimensions of about 25×25 cm (one foot by one foot). As noted above, the cathode target had an overall length of 37.8 cm (14-7/8 inch). As is known in the DC magnetron sputtering art, there is some edge effect or non-uniformity over an approximately 8 cm (three inch) region at the ends of each cathode. However, such non-uniformity is relatively repeatable from one cathode to the next. As noted above and in various reference, the most critical factor in achieving good CIS films is providing the proper ratio of copper to indium deposited. Therefore, while CIS film thickness may vary near the ends of the cathodes 24, this tends to have only secondary affect on overall device quality since proper copper to indium ratios can still be achieved. In a production situation cathodes having essentially any desired length may be used thereby providing not only good stoichiometric ratio but also very uniform film thickness over the entire width of substrates having dimensions of 1.2 m (four feet) or more.

While the above cited references illustrate that numerous techniques have been used to deposit CIS films with mixed results, the above-described process appears to be the optimum for a production situation. As described above, many of the layers needed to fabricate a given device may be deposited in a single pass through a single vacuum chamber. By depositing separate materials from separate cathodes, better precision and uniformity in deposition of each layer can be achieved in an essentially simultaneous process. Thus, the rate of deposition from each cathode is easily controlled by adjustment of the cathode power over a considerable range. As noted above, effective deposition rate can also be increased simply by using multiple cathodes for a given material. In any case, the electrical control of deposition rate leads itself well to automatic computer process control.

While the separate selenization step would appear to increase process time and complexity, it should reduce costs in a production situation. This isn in part due to the fact that selenium is quite diffeent from copper and indium and causes numerous problems when included in the vacuum chamber in which the metals are deposited. This is particularly true in a reactive deposition process where the substrates must be heated. The high temperatures affect many many parts of the vacuum chamber, e.g. the conveyor belt and rollers. The high vapor pressure of selenium insures that in a heated system all parts of the chamber will be exposed to and can be damaged by selenium, for example, the target materials tend to react with selenium and this "poisoning" interferes with control of the deposition process. The presence of selenium in a heated system also increases the risk of loss of a dangerous material from the chamber. The present invention avoids these problems by removing selenium from the vacuum system and operating at room temperature during deposition of copper and indium. Selenization occurs in a separate furnace with no moving parts to be affected by the heat and can be performed at atmospheric pressure. While operating in the batch process mode, the furnace can have a large volume and therefore a high throughput. The net result of this process is an overall cost reduction.

It will be appreciated that all of the benefits of the pressent invention can be achieved regardless of the order of deposition of the copper and indium films. That is, the indium could be deposited first or the films could be deposited as a sandwich or stack of thinner layers. The preferred embodiment uses the one layer of indium on one layer of copper process because it corresponds to the order used in other deposition processes and has given good results.

While the present invention has been illustrated and described with reference to particular apparatus and methods of operation, it will be apparent that various modifications and changes can be made therein within the appended claims.

## Claims

1. A method for fabricating a copper indium diselenide semiconductor film comprising:
depositing a film of copper on a substrate by DC magnetron sputtering;
depositing indium on said film of copper by DC magnetron sputtering to form a composite film of copper and indium;
heating said composite film of copper and indium in the presence of selenium at a temperature and for a time selected to cause interdiffusion of copper, indium and selenium to form a copper indium diselenide film.

2. A method according to Claim 1 wherein said copper and indium are deposited sequentially in a single vacuum chamber by continuously moving said substrate past separate sputtering cathodes.

3. A method according to Claim 1 to Claim 2, wherein said substrate includes a metallic current collecting film and said film is deposited on said substrate, before deposition of said film of copper, by DC magnetron sputtering.

4. A method according to Claim 3, wherein said current collecting film is deposited by:
depositing a layer of chromium on said substrate by DC magnetron sputtering; and
depositing a layer of molybdenum on said chromium layer by DC magnetron sputtering.

5. A method according to Claim 3 or Claim 4, wherein said current collecting film, said film of copper and said indium are deposited sequentially in a single vacuum chamber by continuously moving said substrate past separate sputtering cathodes.

6. A method according to any one of the preceding claims, wherein said substrate is neither heated nor cooled during said depositing steps.

7. A method according to any one of the preceding claims, wherein:

said first film of copper is deposited to a thickness of from about 20 to about 200 nanometres, and
indium is deposited to a thickness of from about 40 to about 400 nanometres,
said thickness being selected to provide an atomic ratio of copper to indium of about 1.0.

8. A method for fabricating a copper indium diselenide semiconductor fvlm comprising:
depositing a layer of indium on a substrate by DC magnetron sputtering;
depositing copper on said layer of indium by DC magnetron sputtering to form a composite film of copper and indium:
heating said composite film of indium and copper in the presence of selenium at a temperature and for a time selected to cause interdiffusion of copper indium and selenium to form a copper indium diselenide film.

## Patentansprüche

1. Verfahren zur Herstellung einer Kupfer-Indium-Diselenid-Halbleiterschicht, das umfaßt:
— Auftragen einer Kupferschicht auf einem Substrat durch DC-Magnetronsputtern;
— Auftragen von Indium auf die Kupferschicht mit DC-Magnetron-sputtern, um eine zusammengesetzte Schicht aus Kupfer und Indium zu bilden;
— Erwärmen der zusammengesetzten Schicht aus Kupfer und Indium in Gegenwart von Selen bei einer Temperatur und über eine Zeit, die ausgewählt sind, um eine gegenseitige Diffusion von Kupfer, Indium und Selen zum bewirken, um eine Kupfer-Indium-Diselenid-Schicht zu bilden.

2. Verfahren nach Anspruch 1, wobei das Kupfer und das Indium nacheinander in einer einzigen Vakuumkammer durch kontinuierliche Bewegung des Substrates an separaten Sputter-Kathoden vorbei aufgetragen werden.

3. Verfahren nach einem der Ansprüche 1 oder 2, wobei das Substrat eine metallene stromabnehmende Schicht enthält und die Schicht auf dem Substrat vor der Auftragung der Kupferschicht durch DC-Magnetronsputtern aufgetragen wird.

4. Verfahren nach Anspruch 3, wobei die stromabnehmende Schicht aufgetragen wird durch:
— Auftragen einer Lage Chrom auf dem Substrat durch DC-Magnetronsputtern; und
— Auftragen einer Lage Molybdän auf die Chromlage durch DC-Magnetronsputtern.

5. Verfahren nach einem der Ansprüche 3 oder 4, wobei die stromabnehmende Schicht, die Kupferschicht und das Indium nacheinander in einer einzigen Vakuumkammer duch kontinuierliches Bewegen des Substrates an separaten Sputterkathoden vorbei aufgetragen werden.

6. Verfahren nach einem der voranstehenden Ansprüche, wobei das Substrat während der Auftragungsscritte weder geheizt noch gekühlt wird.

7. Verfahren nach einem der voranstehenden Ansprüche, wobei:
— die erste Schicht aus Kupfer mit einer Dicke von ungefähr 20 bis ungefähr 200 nm aufgetragen wird, und

— Indium mit einer Dicke von ungefähr 40 bis ungefähr 400 nm aufgetragen wird,

— wobei die Dicke ausgewählt wird, um ein Atom-Verhältnis von Kupfer zu Indium von ungefähr 1, 0 vorzusehen.

8. Verfahren zur Herstellung einer Kupfer-Indium-Diselenid-Halbleiterschicht, das umfaßt:

— Auftragen einer Lage Indium auf ein Substrat durch DC-Magnetronsputtern;

— Auftragen von Kupfer auf die Lage Indium durch DC-Magnetronsputtern, um eine zusammengesetzte Schicht aus Kupfer und Indium zu bilden;

— Erhitzen der zusammengesetzten Schicht aus Indium und Kupfer in der Gegenwart von Selen bei einer Temperatur und über eine Zeit, die ausgewählt sind, un eine gegenseitige Diffusion von Kupfer, Indium und Selen zu bewirken, um eine Kupfer-Indium-Diselenid-Schicht zu bilden.

## Revendications

1. Procédé pour fabriquer un film semiconducteur ce diséléniure de cuivre et d'indium, caractérisé en ce qu'il comprend:

le dépôt d'un film de cuivre sur un substrat par pulvérisation par magnétron à courant continu;

le dépôt d'indium sur ce film de cuivre par pulvérisation par magnétron à courant continu pour former un film composite de cuivre et d'indium;

le chauffage de ce film composite de cuivre et d'indium en présence de sélénium à une température et pendant un temps choisis de façon à provoquer une interdiffusion du cuivre, de l'indium et du sélénium pour former un film de diséléniure de cuivre et d'indium.

2. Procédé suivant la revendication 1, caractérisé en ce que ce cuivre et cet indium sont déposés successivement dans une chambre à vide unique par déplacement continu de ce substrat devant des cathodes de pulvérisation séparées.

3. Procédé suivant la revendication 1 ou la revendication 2, caractérisé en ce que ce substrat comprend un film métallique collecteur de courant et que ce film est déposé sur le substrat avant dépôt de ce film de cuivre par pulvérisation par magnétron à courant continu.

4. Procédé suivant la revendication 3, caractérisé en ce que ce film collecteur de courant est déposé par;

dépôt d'une couche de chrome sur ce substrat par pulvérisation par magnétron à courant continu; et

dépôt d'une couche de molybdène sur cette couche de chrome par pulvérisation par magnétron à courant continu.

5. Procédé suivant la revendication 3 ou la revendication 4, caractérisé en ce que ce film collecteur de courant, ce film de cuivre et cet indium sont déposés successivement dans une chambre à vide unique par déplacement continu de ce substrat devant des cathodes de pulvérisation distinctes.

6. Procédé suivant l'une quelconque des revendications précédentes, caractérisé en ce que ce substrat n'est ni chauffé, ni refroidi pendant ces étapes de dépôt.

7. Procédé suivant l'une quelconque des revendications précédentes, caractérisé en ce que;

ce premier film de cuivre est déposé sur une épaisseur d'environ 20 à 200 nanomètres, et

l'indium est déposé sur une épaisseur d'environ 40 à 400 nanomètres,

ces épaisseurs étant choisies de façon à fournir un rapport atomique de cuivre à indium d'environ 1,0.

8. Procédé pour fabriquer un film seimiconducteur de diséléniure de cuivre et d'indium, caractérisé en ce qu'il comprend;

le dépôt d'une couche d'indium sur un substrat par pulvérisation par magnétron à courant continu;

le dépôt de cuivre sur ce film d'indium par pulvérisation par magnétron à courant continu pour former un film composite de cuivre et d'indium en présence de sélénium à une température et pendant un temps choisis de façon à provoquer une interdiffusion du cuivre, de l'indium et du sélénium pour former un film de diséléniure de cuivre et d'indium.

10 — 22 — 22 — 22

20
18
16
14
12

*FIG. 1*

24 — Cr — 24 — Mo — Cu — In — 24 — DC MAGNETRON SPUTTING CATHODE

12 — 12 — 12

26 — 26 — 25 — 28

*FIG. 2*